# EUROPEAN PATENT APPLICATION

(11) **EP 3 154 319 A1**
(43) Date of publication of application: **12.04.2017**
(21) Application number: 16191675.4
(22) Date of filing: 30.09.2016
(51) Int. Cl.: H05K 3/38, C25D 3/58, C25D 5/10, C25D 5/16, C25D 7/06, C25D 5/48, H05K 1/09

(54) **SURFACE-TREATED COPPER FOIL FOR PCB HAVING FINE-CIRCUIT PATTERN AND METHOD OF MANUFACTURING THE SAME**

(30) Priority: 30.09.2015 KR 20150137422
(71) Applicant: Iljin Materials Co., Ltd., Jeollabuk-do 570-998 (KR)
(72) Inventor: BEOM, Won Jin, 61084 Buk-gu (KR); CHOI, Eun Sil, 55062 Jeonju-si (KR); SONG, Ki Deok, 16593 Suwon-si (KR)
(74) Representative: Zech, Stefan Markus

(57) **Abstract**

The present invention relates to a surface-treated copper foil for a PCB having a fine-circuit pattern and a method of manufacturing the same. The method of manufacturing the surface-treated copper foil for the PCB having the fine-circuit pattern according to the present invention includes a first step of disposing a copper foil as an anode in a plating solution including one or more metallic ions of Co, Ni, Mo, W, Cu, and Fe and forming a metal alloy layer by electrolysis, a second step of forming a roughened layer with a protrusion by roughening the formed metal alloy layer, a third step of forming a Zn coating layer on the roughened layer, a fourth step of forming an electrolytic chromate layer on the coating layer, and a fifth step of forming a silane coupling agent-treated layer on the electrolytic chromate layer.

According to the present invention, the copper foil is surface-treated by forming the metal alloy layer to improve peel strength of the copper foil.

## Description

### [Technical Field]

The present invention relates to a surface-treated copper foil for a PCB having a fine-circuit pattern and a method of manufacturing the same, and more particularly, to a surface-treated copper foil for a PCB having a fine-circuit pattern with excellent adhesion strength with a substrate, heat-resistant adhesion strength, chemical resistance, an etching property by performing roughening on the surface of a copper foil, and a method of manufacturing the same.

### [Background Art]

In recent years, with acceleration of miniaturization and weight reduction of electric/electronic apparatuses, a printed circuit formed on a board has been fine, high-integrated, and miniaturized, and as a result, a copper foil used in a printed circuit board has required various physical properties.

As the copper foil used for manufacturing a rigid printed circuit board, FR-4 prepreg acquired by impregnating an organic fiber resistant to external shock in an epoxy resin is used, which is a low-priced material which requires high adhesion strength, a high heat-resistance characteristic, and chemical resistance and is an insulator used for interlayer insulation. On the contrary, as the copper foil used for manufacturing a flexible printed circuit board, a copper foil showing low roughness, high elongation rate, and a high flexural property is used, which may show the high flexural property and even as the insulator, a polyimide film or vanish having the excellent flexural property is used.

As the most fundamental characteristics required for the copper foil, the adhesion strength between the copper foil and an insulation substrate is required to be excellent. In particular, the adhesion strength needs to be maintained with the required characteristic or more even after various treatments in a subsequent post-treatment process as well as just after heating and pressurizing and laminating the insulation substrate. To this end, the chemical resistance to acid or alkali, the heat resistance, and the like need to be excellent. Further, in an etching process for forming a copper circuit pattern and making the formed copper circuit pattern into a wiring board, an etching property such as a property in which an etching residue does not remain in a non-pattern part, and the like is required to be excellent.

In order to enhance the adhesion strength of the copper foil, a process is generally used, which increases a surface area of the copper foil surface by depositing minute copper particles on the surface of the copper foil, that is, performing roughening on the surface of the copper foil. However, even though the adhesion strength can be enhanced only by simple roughening, the adhesion strength cannot be prevented from being deteriorated by various chemicals or heat in a subsequent process. In order to solve the problem, a treatment for increasing the adhesion strength of the copper foil by executing various post-treatment processes including forming a zinc layer film after the roughening, forming a rust proof treatment layer of an electrolyte chromate layer and a silane coupling agent-treated layer, and the like is executed.

However, technical limits occur, in which when the surface-treated copper foil having minute roughness and excellent adhesion strength is required for fineness of the copper foil for the PCB, but the roughness of the roughening treatment layer becomes fine, the adhesion strength of the surface of the copper foil decreases and it is difficult to achieve all required characteristics including the chemical resistance, the etching property, a heat resistance adhesion strength, and the like of the copper foil.

### [Summary of Invention]

### [Technical Problem]

The present invention is directed to provide a surface-treated copper foil for a PCB having a fine-circuit pattern and a method of manufacturing the same, which surface-treats a copper foil by forming a metal alloy layer to improve a peel strength of the copper foil.

The present invention is also directed to provide a surface-treated copper foil for a PCB having a fine-circuit pattern and a method of manufacturing the same, which surface-treats a copper foil by executing roughening twice to improve a peel strength of the copper foil.

The present invention is also directed to provide a surface-treated copper foil for a PCB having a fine-circuit pattern suitable for being used as a copper foil used for a PCB having a fine-circuit pattern by improving adhesion strength between the surface-treated copper foil and a substrate, heat-resistant adhesion strength, chemical resistance, and an etching property and a method of manufacturing the same.

### [Technical Solution]

An aspect of the present invention provides a surface-treated copper foil for a PCB having a fine-circuit pattern including: a copper foil; a metal alloy layer formed on the copper foil; a roughened layer including a protrusion formed on the metal alloy layer; a Zn coating layer formed on the roughened layer; a chromate layer formed on the Zn coating layer; and a silane coupling agent-treated layer formed on the chromate layer, in which a height of the roughened layer is 1 to 4 µm, a width between the protrusions is 0.5 to 7 µm, and 2 to 35 protrusions are distributed within 15 µm of an observation section.

The metal alloy layer may include at least one metallic ion of Co, Ni, Mo, W, Cu, and Fe.

The composition of the metallic ion included in the metal alloy layer may be Ni ions or Co ions of 10 to 15 g/L, Mo ions or W ions of 0.5 to 1 g/L, and Cu ions or Fe ions of 10 to 20 g/L.

The surface roughness of the roughened layer may be 2.5 µm or less.

The Zn coating layer may be a pure Zn or Zn alloy.

The metallic ion used for forming the Zn alloy coating layer may be at least one metallic ion selected from Ni, Mo, Cr, and Co.

The roughened layer may be constituted by Cu of 4 to 25 g/L, H₂SO₄ of 70 to 125 g/L, and W of 0.005 to 0.04 g/L.

The roughened layer may be constituted by Cu of 4 to 25 g/L, H₂SO₄ of 70 to 125 g/L, W of 0.005 to 0.04 g/L, and Mo 0.1 to 1 g/L.

Another aspect of the present invention provides a method of manufacturing a surface-treated copper foil for a PCB having a fine-circuit pattern including: a first step of disposing a copper foil in a plating solution including at least one metallic ion of Co, Ni, Mo, W, Cu, and Fe as a cathode and electrolyzing the disposed copper foil to form a metal alloy layer; a second step of forming a roughened layer with a protrusion by roughening the formed metal alloy layer; a third step of forming a Zn coating layer on the roughened layer; a fourth step of forming an electrolytic chromate layer on the coating layer; and a fifth step of forming a silane coupling agent-treated layer on the electrolytic chromate layer.

The method may further include performing secondary roughening after forming the roughened layer through the roughening.

The composition of a plating solution used when forming the metal alloy layer may be Ni ions or Co ions of 10 to 15 g/L, Mo ions or W ions of 0.5 to 1 g/L, and Cu ions or Fe ions of 10 to 20 g/L.

A height of a protrusion formed after the roughening may be 1 to 4 µm, a width between the protrusions may be 0.5 to 7 µm, and 2 to 35 protrusions may be distributed within 15 µm of an observation section.

The surface roughness of the roughened layer may be 2.5 µm or less.

The Zn used when forming the Zn coating layer may be a pure Zn or Zn alloy.

The metallic ion used for forming the Zn alloy coating layer may be at least one metallic ion selected from Ni, Mo, Cr, and Co.

The roughening condition may be Cu of 4 to 25 g/L, H₂SO₄ of 70 to 125 g/L, and W of 0.005 to 0.04 g/L.

The roughening condition may be Cu of 4 to 25 g/L, H₂SO₄ of 70 to 125 g/L, W of 0.005 to 0.04 g/L, and Mo 0.1 to 1 g/L.

### [Advantageous Effect]

According to the present invention, a copper foil is surface-treated by forming a metal alloy layer to improve peel strength of the copper foil.

Further, according to the present invention, the copper is surface-treated by executing rouging twice to improve the peel strength of the copper foil.

Further, according to the present invention, a surface-treated copper foil can be acquired, which is suitable for being used as a copper foil for a PCB having a fine-circuit pattern by improving an adhesion strength and a heat-resistant adhesion strength between the copper foil and a substrate, chemical resistance, and an etching property through surface-treatment of the copper foil.

### [Description of Drawings]

FIG. 1 is a flowchart illustrating a method of manufacturing a surface-treated copper foil for a PCB having a fine-circuit pattern according to an exemplary embodiment of the present invention.
FIG. 2 is an SEM photograph illustrating an appearance in which a metal alloy layer is formed when a copper foil is electrolyzed according to the exemplary embodiment of the present invention.
FIG. 3A is an SEM photograph illustrating a state in which a protrusion is formed on the surface of the metal alloy layer when roughening is performed under a condition of including Cu, H₂SO₄, and W.
FIG. 3B is an SEM photograph illustrating a state in which a protrusion is formed on the surface of the metal alloy layer when roughening is performed under a condition of including Cu, H₂SO₄, W and Mo.
FIG. 4 is an SEM photograph illustrating a cross section of the surface-treated copper foil according to the present invention.
FIG. 5 is a schematic diagram illustrating a cross section of the surface-treated copper foil according to the present invention.

### [Description of Embodiment(s)]

Other detailed contents of the exemplary embodiments are included in the description and drawings.

The advantages and features of the present invention, and a method of accomplishing these will become obvious with reference to embodiments to be described below in detail along with the accompanying drawings. However, the present invention is not limited to exemplary embodiments disclosed below but may be implemented in various different forms and in the following description, when it is described that an element is "coupled" to another element, the element may be directly coupled to the other element or coupled to the other element through a third element. Further, the drawings and description are to be regarded as illustrative in nature and not restrictive. Like reference numerals designate like elements throughout the specification.

Hereinafter, the present invention will be described with reference to the accompanying drawings.

[Surface-treated copper foil for PCB having fine-circuit pattern]

A surface-treated copper foil for a PCB having a fine-circuit pattern according to an exemplary embodiment of the present invention includes a copper foil, a metal alloy layer formed on the copper foil, a roughened layer including a protrusion formed on the metal alloy layer, a Zn coating layer formed on the roughened layer, a chromate layer formed on the Zn coating layer, and a silane coupling agent-treated layer formed on the chromate layer. The height of the protrusion of the roughened layer is 1 to 4 µm, a width between the protrusions is 0.5 to 7 µm, and 2 to 35 protrusions are distributed within 15 µm of an observation section.

Meanwhile, surface roughness of the roughened layer of the surface-treated copper foil for the PCB having the fine-circuit pattern is equal to or smaller than 2.5 µm.

The height of the protrusion described in the present invention means a distance between the surface of the metal alloy layer and the apex of the protrusion, and the height of the protrusion of the roughened layer may be in a range of 1 µm to 4 µm. The protrusion is formed on the surface of the metal alloy layer, and when the height of the protrusion is less than 1 µm, it is not preferred that adhesion strength is not excellent due to the small height of the protrusion. When the height of the protrusion is greater than 4 µm, it is not preferred that a deviation in surface roughness of the surface of the copper foil is increased and thus stable adhesion strength may not be maintained.

Further, it is preferred that the width between the protrusions is in a range of 0.5 µm to 7 µm. When the width between the protrusions is less than 0.5 µm, it is not preferred that the distance between the protrusions is decreased and thus the adhesion strength is decreased because adhesion between the surface of the copper foil and the protrusion is weakened. When the width between the protrusions is greater than 7 µm, it is not preferred that the adhesion strength is decreased.

Further, it is preferred that the number of protrusions exists 2 to 35 within 15 µm of an observation section. When the number of protrusions within 15 µm of an observation section is less than 2, it is not preferred that there is a problem in that the adhesion strength is decreased. When the number of protrusions is greater than 35, it is not preferred that the distance between the protrusions is decreased and thus the adhesion strength is rather decreased because adhesion between the surface of the copper foil and the protrusion is weakened.

[Method of manufacturing surface-treated copper foil for PCB having fine-circuit pattern]

### Manufacture of copper foil

In order to manufacture a copper foil by electrolysis, an electrolyzer system having a capacity of 3 L which is circulatable at 20 L/min was used. A copper electrolyte used for manufacturing the copper foil may have a composition of 250 to 400 g/L of CuSO4□5H2O and 80 to 150 g/L of H₂SO₄, and chlorine ions and additives may be added.

Further, the temperature of the copper electrolyte used for manufacturing the copper foil was uniformly maintained at 45°C. A cathode for manufacturing the copper foil uses a dimentionally stable electrode (DSE) plate having a thickness of 5 mm and a size of 10×10cm2. An anode also used a titanium plate having a thickness of 5 mm and a size of 10×10cm2 like the cathode. Further, in order to facilitate the movement of Cu2+ ions, plating was performed with current density of 35 A/dm2 and the copper foil was manufactured with a thickness of 12 µm.

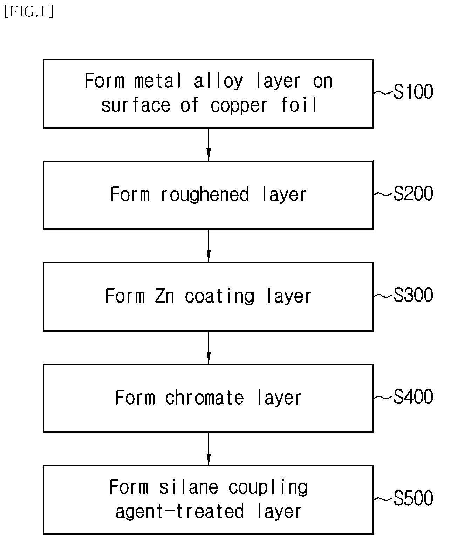

First, a method of manufacturing a surface-treated copper foil for a PCB having a fine-circuit pattern according to an exemplary embodiment of the present invention will be schematically described with reference to FIG. 1. FIG. 1 is a flowchart illustrating a method of manufacturing a surface-treated copper foil for a PCB having a fine-circuit pattern according to an exemplary embodiment of the present invention.

The method of manufacturing the surface-treated copper foil for the PCB having the fine-circuit pattern according to the present invention includes a first step (S100) of disposing a copper foil as an anode in a plating solution including one or more metallic ions of Co, Ni, Mo, W, Cu, and Fe and forming a metal alloy layer by electrolysis, a second step (S200) of forming a roughened layer with a protrusion by roughening the formed metal alloy layer, a third step (S300) of forming a Zn coating layer on the roughened layer, a fourth step (S400) of forming an electrolytic chromate layer on the coating layer, and a fifth step (S500) of forming a silane coupling agent-treated layer on the electrolytic chromate layer.

### Step of forming metal alloy layer

In the first step (S100), a copper foil as an anode is disposed and electrolyzed in a plating solution including one or more metallic ions of Co, Ni, Mo, W, Cu, and Fe. When the copper foil is electrolyzed, the metallic ions used in the plating solution may include one or more metallic ions of Co, Ni, Mo, W, Cu, and Fe. It is preferred that the composition of the plating solution includes 10 to 15 g/L of Ni ions or Co ions, 0.5 to 1 g/L of Mo ions or W ions, and 10 to 20 g/L of Cu ions or Fe ions. When the content of Ni and Co is less than 10 g/L, it is not preferred that the degree of residues after roughening is degraded, and when the content of Ni and Co is greater than 15 g/L, it is not preferred that there is a problem in that a dissolution time is increased and thus productivity is deteriorated. When the content of Mo and W is less than 0.5 g/L, it is not preferred that the metal alloy layer is not formed well and thus the metal alloy layer is not working and the shape of the protrusion is not good, and when the content of Mo and W is greater than 1 g/L, it is not preferred that there is a problem in that a dissolution time is increased and thus the productivity is deteriorated. Further, when the content of Cu and Fe is less than 10 g/L, it is not preferred that there is a problem in that particle sizes of the alloy layer are decreased and thus the adhesion strength is deteriorated. When the content of Cu and Fe is greater than 20 g/L, it is not preferred that the particle sizes of the alloy layer are increased to have a negative effect on roughness and an etching property of the copper foil.

Further, it is preferred that pH when electrolyzing the copper foil is in a range of pH 1.7 to 3.0. When the pH is less than 1.7, it is not preferred that the coating amount of tungsten and molybdenum in the alloy layer is decreased and thus the alloy layer does not play a role, and when the pH is greater than 3.0, it is not preferred that a dissolution time of the selected metal is increased to have a negative effect on the productivity.

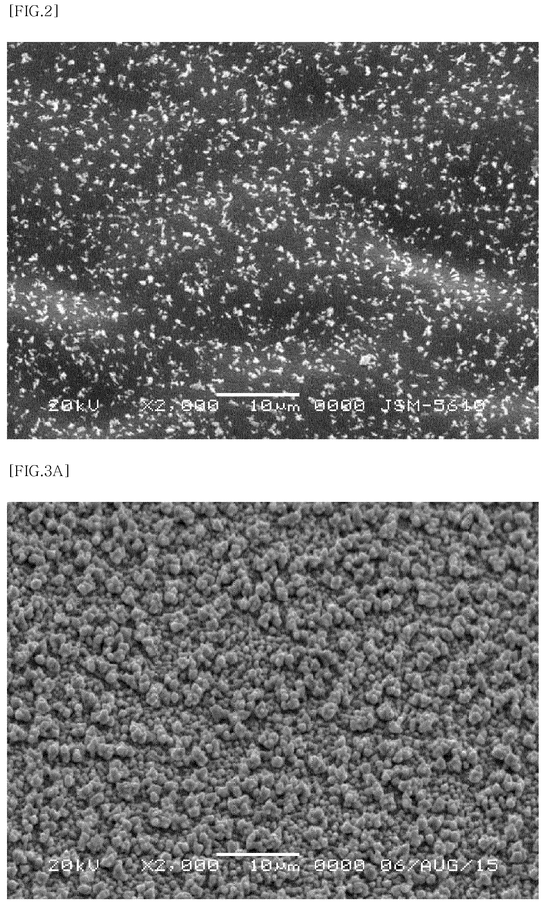

When the metal alloy layer is formed by electrolyzing the copper foil, metallic nuclei having various sizes are generated on the surface of the metal alloy layer. FIG. 2 illustrates an SEM photograph of a state in which the metallic nuclei are generated on the surface of the metal alloy layer when the metal alloy layer is formed by electrolyzing the copper foil. Referring to FIG. 2, it can be verified that the metallic nuclei having various sizes are generated in a bright particular shape.

### Step of forming roughened layer

In the second step (S200), the roughened layer with the protrusion is formed by roughening the alloy layer formed in the first step. The protrusion is formed on the surface of the copper foil roughened in the second step (S200). When the protrusion is formed on the surface of the alloy layer of the copper foil by roughening, the surface area of the copper foil is increased and as a result, the protrusion serves to increase adhesion with an insulator to be used in a process after manufacturing the copper foil. It is preferred that the surface roughness of the copper foil which is roughened is equal to or smaller than 2.5 µm.

The roughening particles for forming the protrusion are formed by at least two kinds of alloys selected from Cu, H₂SO₄, W, and Mo, and the roughened layer may be formed by variously combining compositions of roughened metallic ions. The roughening may be performed under an electrolyte condition of Cu 4 to 25 g/L, H₂SO₄ 125 g/L to 130 g/L, and W 0.005 g/L to 0.04 g/L. Alternatively, the roughening may be performed under an electrolyte condition of Cu 4 to 25 g/L, H₂SO₄ 125 g/L to 130 g/L, Mo 0.1 to 1 g/L, and W 0.005 g/L to 0.04 g/L.

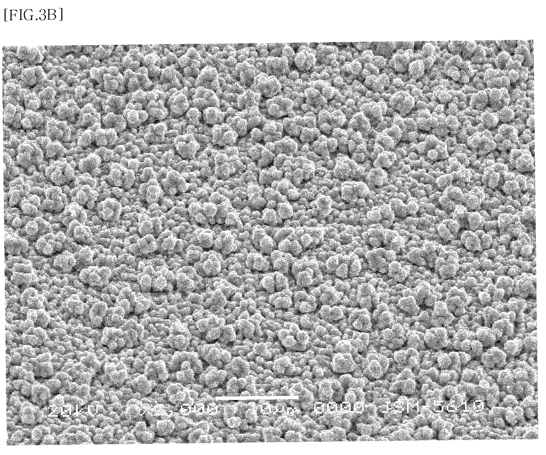

FIG. 3A is an SEM photograph illustrating a state in which a protrusion is formed on the surface of the metal alloy layer when roughening is performed under an electrolyte condition of including Cu, H₂SO₄, and W. Further, FIG. 3B is an SEM photograph illustrating a state in which a protrusion is formed on the surface of the metal alloy layer when roughening is performed under an electrolyte condition of including Cu, H₂SO₄, Mo and W.

Further, in the second step (S200), after the roughened layer is formed by roughening the copper foil with the metal alloy layer, secondary roughening may be performed. The secondary roughening is performed to more enhance peel strength.

Meanwhile, it is preferred that the height of the protrusion formed on the surface of the copper foil which is roughened in the second step (S200) is in a range of 1 µm to 4 µm. The height of the protrusion described in the present invention means a distance between the surface of the metal alloy layer and the apex of the protrusion.

The protrusion is formed on the metal alloy layer, and when the height of the protrusion is less than 1 µm, it is not preferred that the adhesion strength is not excellent due to the small height of the protrusion. When the height of the protrusion is greater than 4 µm, it is not preferred that a deviation in surface roughness of the surface of the copper foil is increased and thus stable adhesion strength may not be maintained.

Further, it is preferred that the width between the protrusions is in a range of 0.5 µm to 7 µm. When the width between the protrusions is less than 0.5 µm, it is not preferred that the distance between the protrusions is decreased and thus the adhesion strength is decreased because adhesion between the surface of the copper foil and the protrusion is weakened. When the width between the protrusions is greater than 7 µm, it is not preferred that the adhesion strength is decreased.

Further, it is preferred that the number of protrusions exists 2 to 35 within 15 µm of an observation section. When the number of protrusions within 15 µm of an observation section is less than 2, it is not preferred that there is a problem in that the adhesion strength is decreased. When the number of protrusions is greater than 35, it is not preferred that the distance between the protrusions is decreased and thus the adhesion strength is rather decreased because adhesion between the surface of the copper foil and the protrusion is weakened.

### Step of forming Zn coating layer

Next, the third step (S300) of forming the Zn coating layer on the roughened layer formed above is performed. The coating layer is formed by precipitating a pure Zn or Zn alloy coating layer, and the used Zn alloy may use a Zn-Ni alloy, a Mg-Zn alloy, a Zn-Cr alloy, a Zn-Co alloy, a Zn-Ni-Co alloy, a Zn-Ni-Mo alloy, and a Zn-Co-Mo alloy. When the coating layer is formed, it is preferred that the composition of the electrolyte includes 0.5 g/L to 15 g/L of Zn metal ions and 0.1 g/L to 10 g/L of at least one metal ions of Ni, Mo, Cr, and Co. The forming of the coating layer may be performed under conditions of pH of 3.0 to 4.0, current density of 0.1 to 3 A/dm2, and a treatment time of 1 to 4 seconds at room temperature. However, the performing condition is not necessarily limited thereto and the coating layer may be formed under a generally used condition.

### Step of forming chromate layer

The fourth step (S400) of forming the electrolytic chromate layer after forming the Zn coating layer is performed. It is preferred that the forming of the electrolytic chromate layer is performed under an electrolytic bath of a CrO₃ concentration of 0.1 to 10 g/L, pH of 4.0 to 5.0, current density of 0.2 to 2 A/dm2, and a treatment time of 2 to 5 seconds at room temperature. However, the performing condition is not necessarily limited thereto and the electrolytic chromate layer may be formed under a generally used condition. When the chromate treatment is performed on the Zn coating layer, a rust prevention layer made of chromium hydroxide and chromium oxide is formed.

### Step of forming silane coupling agent-treated layer

Finally, the fifth step (S500) of forming the silane coupling agent-treated layer on the chromate layer is performed. It is preferred that the silane coupling agent treatment is performed by a method of diluting a silane coupling agent of 0.005 to 2 wt% with water to coat and dry the silane coupling agent on the chromate layer. However, the performing condition is not necessarily limited thereto and the coating layer may be formed under a generally used condition.

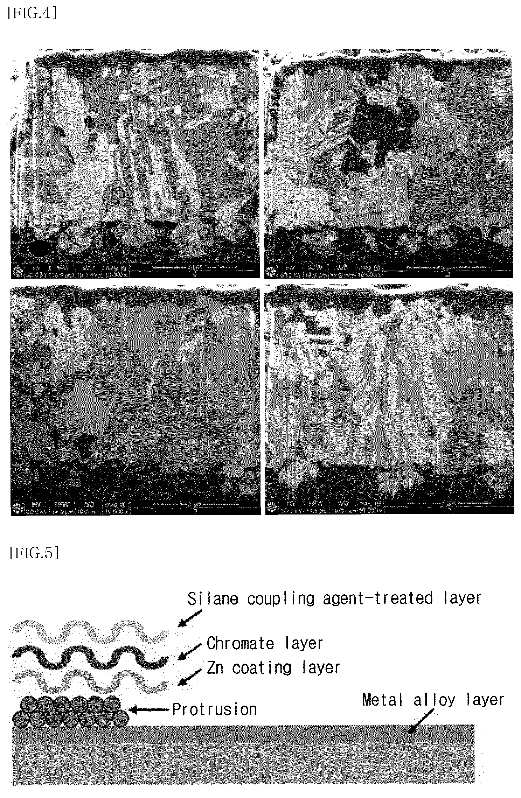

For reference, FIG. 4 is an SEM photograph illustrating a cross section of the surface-treated copper foil according to the present invention. As described above, it can be seen that the protrusion is formed on the bottom of the surface-treated copper foil which is performed up to the forming of the silane coupling agent-treated layer as illustrated in FIG. 4.

Further, FIG. 5 is a schematic diagram illustrating a cross section of the surface-treated copper foil according to the present invention. As described above, it can be seen that the protrusion is formed on the metal alloy layer and the Zn coating layer, the chromate layer, and the silane coupling agent-treated layer are formed in sequence.

### [Examples]

Hereinafter, the present invention will be described in more detail through Examples.

In order to measure peel strength, residues, an etching property, and the like of a surface-treated copper foil for a PCB having a fine-circuit pattern according to Example, the following experimental groups were tested.

In Examples and Comparative Examples, forming a coating layer, forming an electrolytic chromatic layer on the coating layer, and forming a silane coupling agent-treated layer on the electrolytic chromatic layer were performed under a generally used condition. Residues, an etching property, peel strength, and surface roughness of the surface-treated copper foil for a PCB having a fine-circuit pattern of the present invention were compared by giving a change in forming a metal alloy layer by electrolysis and forming a roughened layer.

Experimental conditions in Examples of the present invention and Comparative Examples are as follows.

### Example 1

First, in Example 1, in order to form a metal alloy layer on the surface of the copper foil manufactured by the aforementioned method, the copper foil was electroplated by using an electrolyte having a range of 10 g/L of Ni ions or Co ions, 0.5 g/L of W ions or Mo ions, and 10 g/L of Cu ions or Fe ions. In plating, a metal alloy layer was formed on the surface of the copper foil by electroplating at current density of 0.5 to 10 A/dm2 for 1 to 5 seconds. In Example 1, forming a protrusion by forming and roughening only the metal alloy layer was omitted and forming a Zn coating layer, forming an electrolytic chromate layer, and forming a silane coupling agent-treated layer were sequentially performed. The Zn coating layer was formed at room temperature under conditions of ZnSO₄.H₂O 5 g/L, pH 3.0, current density of 1 A/dm2, and a treatment time of 4 seconds. Further, the chromate layer was formed at room temperature under conditions of CrO₃ concentration 5g/L, pH 5.0, current density of 0.5 A/dm2, and a treatment time of 4 seconds. Further, the silane coupling agent-treated layer was formed by coating a 0.1 wt% aqueous solution of 3-glycidoxy propyl trimethoxysilane by a sprayer after forming the chromate layer and then drying the aqueous solution in a drying furnace at 150°C.

### Example 2

In Example 2, in order to form a metal alloy layer on the surface of the copper foil manufactured by the aforementioned method, a copper foil was electroplated by using an electrolyte having a range of 10 g/L of Ni ions or Co ions, 0.5 g/L of W ions or Mo ions, and 10 g/L of Cu ions or Fe ions. In plating, a metal alloy layer was formed on the surface of the copper foil by electroplating at current density of 0.5 to 10 A/dm2 for 1 to 5 seconds. For roughening of forming a protrusion after forming the metal alloy layer, a roughened layer was formed by using an electrolyte having a range of Cu 10 g/L, H₂SO₄ 70 g/L, W 0.020 g/L. In Example 2, the roughened layer was formed by electrolyzing at current density of 35 A/dm2 for 1 to 5 seconds during roughening and secondary roughening was performed under the same condition. Thereafter, forming a Zn coating layer, forming an electrolytic chromate layer, and forming a silane coupling agent-treated layer were sequentially performed and the treatment condition was performed by the same condition as Example 1.

### Example 3

In Example 3, in order to form a metal alloy layer on the surface of the copper foil manufactured by the aforementioned method, the copper foil was electroplated by using an electrolyte having a range of 10 g/L of Ni ions or Co ions, 0.5 g/L of W ions or Mo ions, and 10 g/L of Cu ions or Fe ions. In plating, a metal alloy layer was formed on the surface of the copper foil by electroplating at current density of 0.5 to 10 A/dm2 for 1 to 5 seconds. For roughening of forming a protrusion after forming the metal alloy layer, a roughened layer was formed by using an electrolyte having a range of Cu 25 g/L, H₂SO₄ 125 g/L, Mo 0.5 g/L, and W 0.010 g/L. In Example 3, the roughened layer was formed by electrolyzing at current density of 35 A/dm2 for 1 to 5 seconds during roughening and secondary roughening was performed under the same condition. Thereafter, forming a Zn coating layer, forming an electrolytic chromate layer, and forming a silane coupling agent-treated layer were sequentially performed and the treatment condition was performed by the same condition as Example 1.

### Comparative Example 1

In Comparative Example 1, forming a metal alloy layer on the copper foil manufactured by the aforementioned method was omitted and roughening was immediately performed on the copper foil. In Comparative Example 1, for roughening, a roughened layer was formed by using an electrolyte having a range of Cu 10g/L, H₂SO₄ 70g/L, W 0.020 g/L. In Comparative Example 1, the roughened layer was formed by electrolyzing at current density of 35 A/dm2 for 1 to 5 seconds during roughening and secondary roughening was performed under the same condition. Thereafter, forming a Zn coating layer, forming an electrolytic chromate layer, and forming a silane coupling agent-treated layer were sequentially performed and the treatment condition was performed by the same condition as Example 1.

### Comparative Example 2

In Comparative Example 2, forming a metal alloy layer on the copper foil manufactured by the aforementioned method was omitted and roughening was immediately performed on the copper foil. In Comparative Example 2, for roughening, a roughened layer was formed by using an electrolyte having a range of Cu 25 g/L, H₂SO₄ 125 g/L, Mo 0.5 g/L, and W 0.010 g/L. In Comparative Example 2, the roughened layer was formed by electrolyzing at current density of 35 A/dm2 for 1 to 5 seconds during roughening and secondary roughening was performed under the same condition. Thereafter, forming a Zn coating layer, forming an electrolytic chromate layer, and forming a silane coupling agent-treated layer were sequentially performed and the treatment condition was performed by the same condition as Example 1.

Table 1 below is a table illustrating surface roughness Rz and Rmax, peel strength, residues, and an etching property of the copper foil which is surface-treated under conditions of Examples 1 to 3, Comparative Example 1 and Comparative Example 2. The surface roughness Rz and Rmax was measured according to a JISB 0601-1994 standard. The peel strength was measured by attaching a specimen prepared in halogen-free prepreg for Low Dk with a size of 10×100 mm, preparing a specimen for measuring the peel strength by performing a hot pressing process for 30 minutes at 210°C, and setting the prepared measuring specimen at a velocity of 50 mm per minute in U.T.M. equipment.

In an item of "residue" in Table 1 below, "O" means that the residues were generated after surface-treatment of the copper foil and "X" means that the residues after surface-treatment were generated. Further, in item of "etching property" in Table 1 below, "O" means that there is no residue copper or alloy layer remaining on the substrate after etching, and "X" means that there is a lot of residue copper or alloy layer remaining on the substrate after etching. For reference, the surface roughness Rz and Rmax means that as the value is decreased, unevenness is smaller.

**[Table 1]**

| Classification | Rz (µm) | Rmax (µm) | Peel strength (kgf/cm) | Residues | Etching property |
|---|---|---|---|---|---|
| Example 1 | 1.10 | 1.90 | 0.57 | O | O |
| Example 2 | 1.30 | 1.92 | 0.89 | O | O |
| Example 3 | 1.80 | 2.22 | 0.92 | O | O |
| Comparative Example 1 | 2.00 | 2.84 | 0.52 | X | O |
| Comparative Example 2 | 2.50 | 3.27 | 0.72 | X | X |

Referring to Table 1, in Example 1 in which the roughening is omitted and the treatment of the metal alloy layer is performed, surface roughness Rz and Rmax are 1.10 µm and 1.90 µm, respectively, and peel strength is 0.57 kgf/cm, and thus the surface roughness and the peel strength are good. Further, there are no residues and the etching property is also good.

Examples 2 and 3 are Examples tested by varying the roughening condition as described above. In Example 2 in which the roughened layer is formed by including Cu, H₂SO₄, and W in the roughened electrolyte, it can be seen that surface roughness Rz and Rmax are 1.30 µm and 1.92 µm, respectively, and peel strength is 0.89 kgf/cm and thus both surface roughness and the peel strength are excellent as compared with Example 1 in which roughening is omitted.

Meanwhile, in Comparative Example 1 in which surface treatment is performed under the same roughening condition as Example 2 without treating the metal alloy layer, it is shown that surface roughness Rz and Rmax are 2.00 µm and 2.84 µm, respectively, and peel strength is 0.52 kgf/cm and thus both the surface roughness and the peel strength are lower than Example 2 and residues after surface treatment are also generated.

Further, Example 3 is an example in which the roughened layer is formed by including Cu, H₂SO₄, Mo, and W in the roughened electrolyte, and it can be seen that surface roughness Rz and Rmax are 1.80 µm and 2.22 µm, respectively, and peel strength is 0.92 kgf/cm and thus both the surface roughness and the peel strength of Example 3 are excellent as compared with Example 1 in which roughening is omitted.

Meanwhile, in Comparative Example 2 in which surface treatment is performed under the same roughening condition as Example 3 without treating the metal alloy layer, it is shown that surface roughness Rz and Rmax are 2.50 µm and 3.27 µm, respectively, and peel strength is 0.72 kgf/cm and thus both the surface roughness and the peel strength are lower than Example 3, residues after surface treatment are also generated, and the etching property is also not good. It is shown that in Examples of the present invention, in order to enhance surface roughness, peel strength, and an etching property of the surface-treated copper foil, it is preferred that the copper foil is surface-treated by performing the roughening after treating the metal alloy layer.

Those skilled in the art to which the present invention belongs will be able to understand that the present invention can be implemented in other detailed forms without changing the technical spirit or an essential characteristic. Therefore, it should be understood that the aforementioned exemplary embodiments are illustrative in terms of all aspects and are not limited. The scope of the present invention is represented by the claims to be described below rather than the detailed description, and it is to be interpreted that the meaning and scope of the claims and all the changes or modified forms derived from the equivalents thereof come within the scope of the present invention.

## Claims

1. A surface-treated copper foil for a PCB having a fine-circuit pattern, comprising:
a copper foil;
a metal alloy layer formed on the copper foil;
a roughened layer including a protrusion formed on the metal alloy layer;
a Zn coating layer formed on the roughened layer;
a chromate layer formed on the Zn coating layer; and
a silane coupling agent-treated layer formed on the chromate layer,
wherein a height of the roughened layer is 1 to 4 µm, a width between the protrusions is 0.5 to 7 µm, and 2 to 35 protrusions are distributed within 15 µm of an observation section.

2. The surface-treated copper foil for a PCB having a fine-circuit pattern of claim 1, wherein the metal alloy layer includes at least one metallic ion of Co, Ni, Mo, W, Cu, and Fe.

3. The surface-treated copper foil for a PCB having a fine-circuit pattern of claim 2, wherein the composition of the metallic ion included in the metal alloy layer is Ni ions or Co ions of 10 to 15 g/L, Mo ions or W ions of 0.5 to 1 g/L, and Cu ions or Fe ions of 10 to 20 g/L.

4. The surface-treated copper foil for a PCB having a fine-circuit pattern of claim 1, wherein the surface roughness of the roughened layer is 2.5 µm or less.

5. The surface-treated copper foil for a PCB having a fine-circuit pattern of claim 1, wherein the Zn coating layer is a pure Zn or Zn alloy.

6. The surface-treated copper foil for a PCB having a fine-circuit pattern of claim 5, wherein the metallic ion used for forming the Zn alloy coating layer is at least one metallic ion selected from Ni, Mo, Cr, and Co.

7. The surface-treated copper foil for a PCB having a fine-circuit pattern of claim 1, wherein the roughened layer is constituted by Cu of 4 to 25 g/L, H₂SO₄ of 70 to 125 g/L, and W of 0.005 to 0.04 g/L.

8. The surface-treated copper foil for a PCB having a fine-circuit pattern of claim 1, wherein the roughened layer is constituted by Cu of 4 to 25 g/L, H₂SO₄ of 70 to 125 g/L, W of 0.005 to 0.04 g/L, and Mo 0.1 to 1 g/L.

9. A method of manufacturing a surface-treated copper foil for a PCB having a fine-circuit pattern, comprising:
a first step of disposing a copper foil in a plating solution including at least one metallic ion of Co, Ni, Mo, W, Cu, and Fe as a cathode and electrolyzing the disposed copper foil to form a metal alloy layer;
a second step of forming a roughened layer with a protrusion by roughening the formed metal alloy layer;
a third step of forming a Zn coating layer on the roughened layer;
a fourth step of forming an electrolytic chromate layer on the coating layer; and
a fifth step of forming a silane coupling agent-treated layer on the electrolytic chromate layer.

10. The method of claim 9, further comprising:
performing secondary roughening after forming the roughened layer through the roughening.

11. The method of claim 9, wherein the composition of a plating solution used when forming the metal alloy layer is Ni ions or Co ions of 10 to 15 g/L, Mo ions or W ions of 0.5 to 1 g/L, and Cu ions or Fe ions of 10 to 20 g/L.

12. The method of claim 9, wherein a height of a protrusion formed after the roughening is 1 to 4 µm, a width between the protrusions is 0.5 to 7 µm, and 2 to 35 protrusions are distributed within 15 µm of an observation section.

13. The method of claim 9, wherein the surface roughness in the roughening is 2.5 µm or less

14. The method of claim 9, wherein the Zn used when forming the Zn coating layer is a pure Zn or Zn alloy.

15. The method of claim 14, wherein the metallic ion used for forming the Zn alloy coating layer is at least one metallic ion selected from Ni, Mo, Cr, and Co.

16. The method of claim 9, wherein the roughening condition is Cu of 4 to 25 g/L, H₂SO₄ of 70 to 125 g/L, and W of 0.005 to 0.04 g/L.

17. The method of claim 9, wherein the roughening condition is Cu of 4 to 25 g/L, H₂SO₄ of 70 to 125 g/L, W of 0.005 to 0.04 g/L, and Mo 0.1 to 1 g/L.
